(19) **Europäisches Patentamt**

**European Patent Office**

**Office européen des brevets**

(11) **EP 0 977 359 B1**

(12) **EUROPEAN PATENT SPECIFICATION**

(45) Date of publication and mention
of the grant of the patent:
**05.03.2003 Bulletin 2003/10**

(51) Int Cl.7: **H03H 17/04**

(21) Application number: **98114111.2**

(22) Date of filing: **28.07.1998**

(54) **A digital filter for real, complex and m-times multiplexed signals**

Digitales Filter für reale, komplexe und m-fach gemultiplexte Signale

Filtre numérique pour signaux réels, complexe et m-fois multiplexé

(84) Designated Contracting States:
**DE FR GB**

(43) Date of publication of application:
**02.02.2000 Bulletin 2000/05**

(73) Proprietor: **Sony International (Europe) GmbH
10785 Berlin (DE)**

(72) Inventor: **Wildhagen, Jens,
c/o Sony Int. (Europe) GmbH
70736 Fellbach (DE)**

(74) Representative: **Müller, Frithjof E., Dipl.-Ing.
Müller Hoffmann & Partner
Patentanwälte
Innere Wiener Strasse 17
81667 München (DE)**

(56) References cited:
**DE-A- 2 263 308**      **US-A- 3 930 147**

- **HATAMIAN M ET AL: "AN 85-MHZ
FOURTH-ORDER PROGRAMMABLE IIR
DIGITAL FILTER CHIP" IEEE JOURNAL OF
SOLID-STATE CIRCUITS, vol. 27, no. 2, 1
February 1992, pages 175-183, XP000289375**

**Description**

This invention is concerned with the realization of a digital filter, in particular with the realization of a digital filter of order N that can be used to filter real, complex or M-times multiplexed signals.

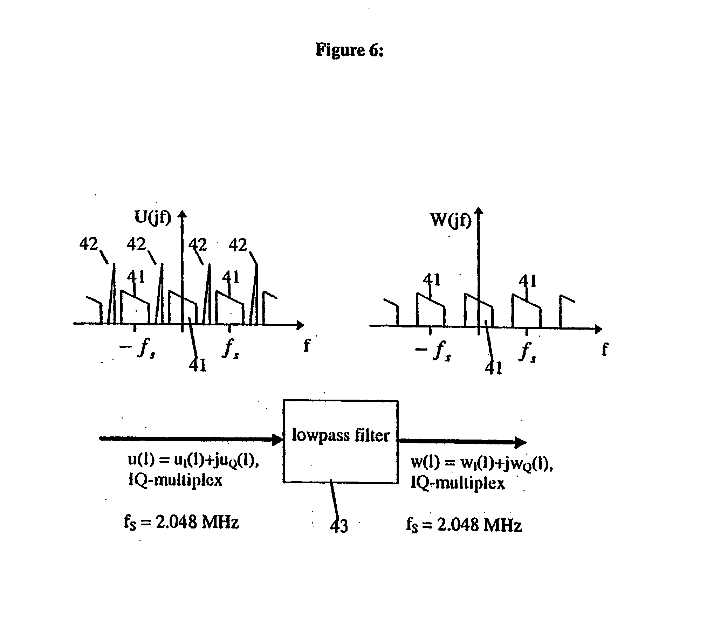

In the field of digital audio broadcasting, i. e. DAB, it is known to suppress the remaining parts 42 of the neighbour channel in the complex baseband signal by digital lowpass filtering to extract only the DAB-signal 41, as it is shown in figure 6. Therefore, a digital lowpass filter 43 receives the complex baseband signal $u(1) = u_I(1) + ju_Q(1)$ that has a sampling rate of $f_S = 2.048$ MHz and outputs the filtered complex baseband signal $w(1) = w_I(1) + jw_Q(1)$ that does not comprise the remaining parts of a neighbour channel 42 in the same IQ-multiplex also with a sampling rate $f_S = 2.048$ MHz.

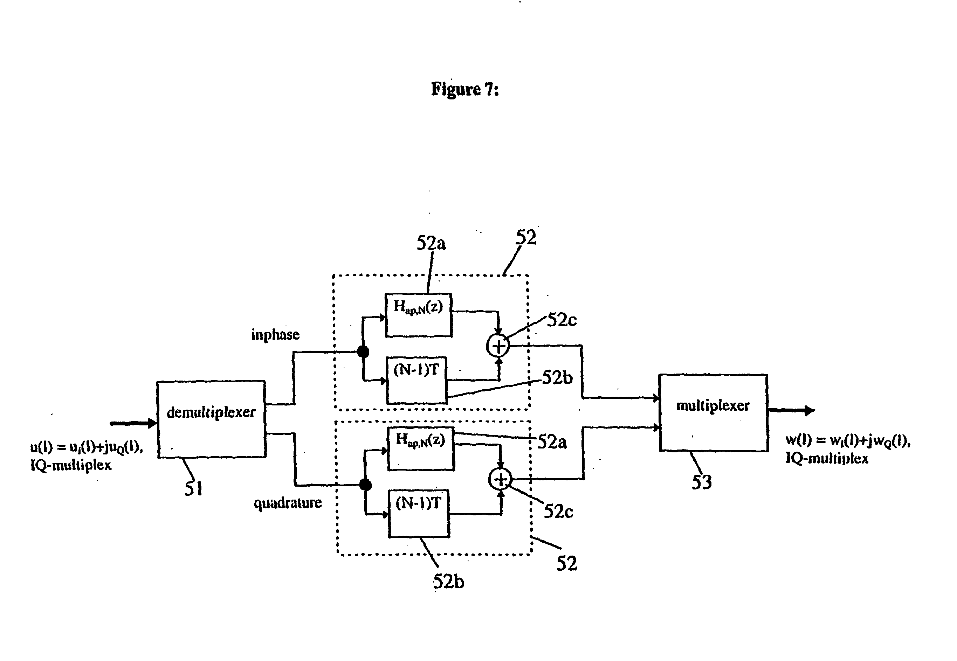

Figure 7 shows such a lowpass filter 43 in detail. The first stage in the digital lowpass filter 43 is a demultiplexer 51 receiving the IQ-multiplexed complex baseband signal $u(1)$ and outputting the inphase component and the quadrature component. Each of these components is fed to a lowpass filter 52 for real signals where it gets filtered to be recombined with a multiplexer 53 to become the IQ-multiplexed filtered signal $w(1)$. Each of the digital lowpass filters 52 is realized by a parallel connection of an allpass filter 52a $N^{th}$ order with a transfer function $H_{ap,N}(z)$ and a delay element $(N-1)^{th}$ order 52b which output signals are combined with an adder 52c.

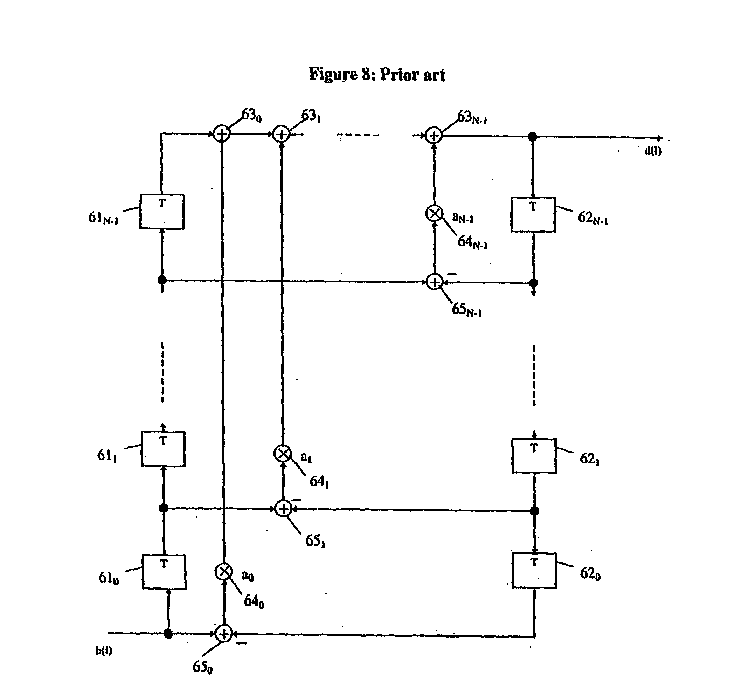

Figure 8 shows a possible realization of such a digital allpass filter 52a $N^{th}$ order. It consists of N delay elements $61_0$ to $61_{N-1}$ that are connected in series and respectively delay an incoming signal $b(1)$ that can be the inphase or the quadrature component in the above example and that is input to the first delay element $61_0$ by one clock period $T_S$, N corresponding adders $65_0...65_{N-1}$ that respectively receive the input signal of a delay element $61_0...61_{N-1}$ as a first input signal, N corresponding multipliers $64_0...64_{N-1}$ that respectively multiply the output signal of a corresponding first adder $65_0...65_{N-1}$ with a corresponding filter coefficient $a_0...a_{N-1}$, N corresponding second adders $63_0...63_{N-1}$ that are connected in series whereby the first adder $63_0$ receives the output signal of the last delay element $61_{N-1}$ as its first input signal, all other adders $63_1...63_{N-1}$ respectively receive the output signal of the respective preceding adder $63_0...63_{N-2}$ as its first input signal and the last adder $63_{N-1}$ outputs an output signal $d(1)$ of the digital allpass filter 52a, each of the adders $63_0...63_{N-1}$ receives as second input signal the output of a respective corresponding multiplier $64_0...64_{N-1}$ to add the respective first and second input signals, and N corresponding second delay elements $62_{N-1}...62_0$ that are connected in series and respectively delay an incoming signal by one clock period $T_S$ whereby the first delay element $62_{N-1}$ receives the output signal $d(1)$ of the digital allpass filter 52a and the output signal of each delay element $62_{N-1}...62_0$ is additionally input to a corresponding first adder $65_{N-1}...65_0$ as a second input signal to be subtracted from the respective first input signal of said first adder $65_{N-1}...65_0$.

Such a recursive allpass filter having a transfer function shown in the following formula (1)

$$H_{ap,N}(z) = \frac{D(z)}{B(z)} = \frac{a_0 z^N + a_1 z^{N-1} + a_2 z^{N-2} + ... + a_{N-1}z + 1}{z^N + a_{N-1}z^{N-1} + a_{N-2}z^{N-2} + a_{N-3}z^{N-3} + ... + a_1 z + a_0} \tag{1}$$

with

$$z = e^{j\Omega}$$

$$\Omega = \frac{2\pi f}{f_s}$$

$f_s$: sampling rate

can also be realized in different ways as it is known in the art, for example as it is disclosed by E. Schrüfer "Signalverarbeitung: numerische Verarbeitung digitaler Signale", 1990 Carl Hansa Verlag München Wien.

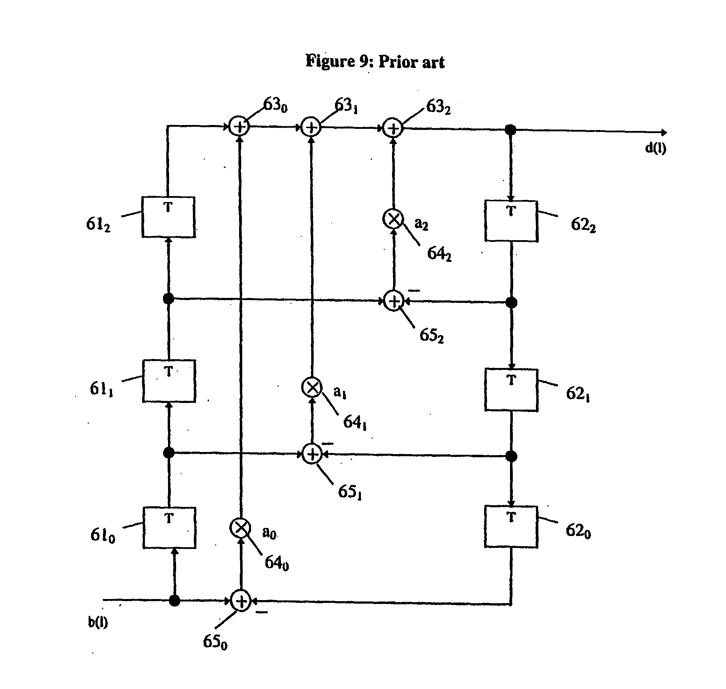

Figure 9 shows the realization of an allpass filter $3^{rd}$ order according to the structure shown in figure 8. Therefore, this allpass filter consists of three first delay elements $61_0$ to $61_2$, three corresponding first adders $65_0$ to $65_2$, three corresponding multipliers $64_0$ to $64_2$, three corresponding second adders $63_0$ to $63_2$ and three corresponding second delay elements $62_2$ to $62_0$, that means in total six delay elements, six adders and three multipliers. This allpass filter $3^{rd}$ order has the following transfer function (formula 2):

$$H_{ap,N}(z) = \frac{D(z)}{B(z)} = \frac{a_0 z^3 + a_1 z^2 + a_2 z + 1}{z^3 + a_2 z^2 + a_1 z + a_0} \qquad (2)$$

with

$$z = e^{j\Omega}$$

$$\Omega = \frac{2\pi f}{f_s}$$

$f_s$:     sampling rate.

Such allpass filters 52a can also be used for the design of lowpass and highpass filters as it is described in Max Gerken et al. "On the design of recursive digital filters consisting of a parallel connection of allpass sections and delay elements", AEÜ, vol. 49 (1995), No. 1, pages 1 to 11. Of course, it is also possible to design a digital bandpass filter with the combination of a lowpass filter and a highpass filter.

It can be seen that such digital allpass filters can be generally employed for different filtering purposes. However, the realization of such allpass filters is quite costly since a big number of adders and multipliers have to be used.

US 3,930,147 discloses a non-recursive digital filter including a coefficient generator, a delay device, a multiplier, and an adder, having an AND-gate switch in the adder/delay device loop for controlling the recursive input to the adder. Further, it is disclosed that a recursive digital filter might be designed by using two of the disclosed non-recursive digital filters.

Therefore, it is the object of the present invention to provide a digital filter of order N, in particular a recursive filter, that needs less adders and multipliers than state of the art filters. Furtheron, it is the object of the present invention to simplify the structure of such a digital filter that can filter IQ-multiplexed complex signals. The designed filter should be usable as highpass, lowpass or allpass filter.

The objects of the present invention are achieved with a digital filter of order N that receives a M-times multiplexed input signal with a sampling rate $f_S$ and outputs a M-times multipieced output signal with said sampling rate $f_S$ that comprises a modified allpass filter of order 1 in which N filter coefficients get periodically switched with a clock frequency $f_c$ that equals to M·N-tlmes said sampling rate $f_S$ to set the filter periodically into M·N internal filter states in each of which an internal output value is calculated before outputting one complete sample of the M-times multiplexed output signal, and is characterized by a first ringbuffer receiving the input signal with said sampling rate $f_S$ and respectively outputting the corresponding input samples needed to calculate an internal filter state with said clock frequency; and a second ringbuffer receiving the Internal output values of the filter in every internal filter state and respectively outputting the corresponding Internal output value needed to calculate a next internal filter state with said clock frequency $f_c$.

With this structure the digital filter of order N, in particular a recursive filter, according to the present Invention has several advantages. The main advantage is that the realization costs can be reduced dramatically, since less adders and multipliers are needed with the solution to switch the filter coefficients and calculate internal intermediate results with a higher clock frequency than the sampling rate $f_S$ of the input or output signal before outputting one sample of the output signal. Furtheron, the two digital filters for the inphase and quadrature component that are needed to filter an IQ-multiplexed signal can be realized by one filter according to the present invention, again reducing the realization costs. Generally, one digital filter of order N according to the present invention can filter M-times multiplexed signals without any additional multipliers or adders, here one complete sample of the M-times multiplexed signal means all M values representing said signal at a point of time, e.g. the values $w_I(1)$ and $w_Q(1)$ in case of a complex signal $w(1) = w_I(1) + jw_Q(1)$. Also, according to the present invention a very easy changing of the transfer function of the filter can be realized by switching to different filter coefficients or a different set of filter coefficients. Therefore, the filter can also be switched easily from one transfer function to another transfer function, e. g. from lowpass filter mode to highpass filter mode, with a different set of filter coefficients. This leads not to increased realization costs, since the filtercoefficients get switched in any case.

Further preferable embodiments of the present invention are defined in dependent claims 2 to 13.

The present invention and its exemplatory advantageous preferred embodiments will be better understood from the following detailed description in connection with the accompanying drawings, in which:

**Figure 1**     shows a block diagram of a digital allpass filter Nth order according to a first embodiment of the present invention;

**Figure 2** shows a block diagram of a digital allpass filter $N^{th}$ order according to a second embodiment of the present invention;

**Figure 3** shows a block diagramm of a digital allpass filter $N^{th}$ order for M-times multiplexed signals according to a third embodiment of the present invention;

**Figure 4** shows an alternative block diagramm of a digital allpass filter $N^{th}$ order for M-times multiplexed signals according to a fourth embodiment of the present invention;

**Figure 5** shows a block diagram of a digital filter $3^{rd}$ order according to a fifth embodiment of the present invention that can be switched between lowpass and highpass mode;

**Figure 6** shows a lowpass filter for the nearby selectivity in a DAB-receiver;

**Figure 7** shows a block diagram of the nearby filter shown in figure 6;

**Figure 8** shows a block diagram of an allpass filter $N^{th}$ order according to the prior art; and

**Figure 9** shows a block diagram of an allpass filter $3^{rd}$ order according to the prior art.

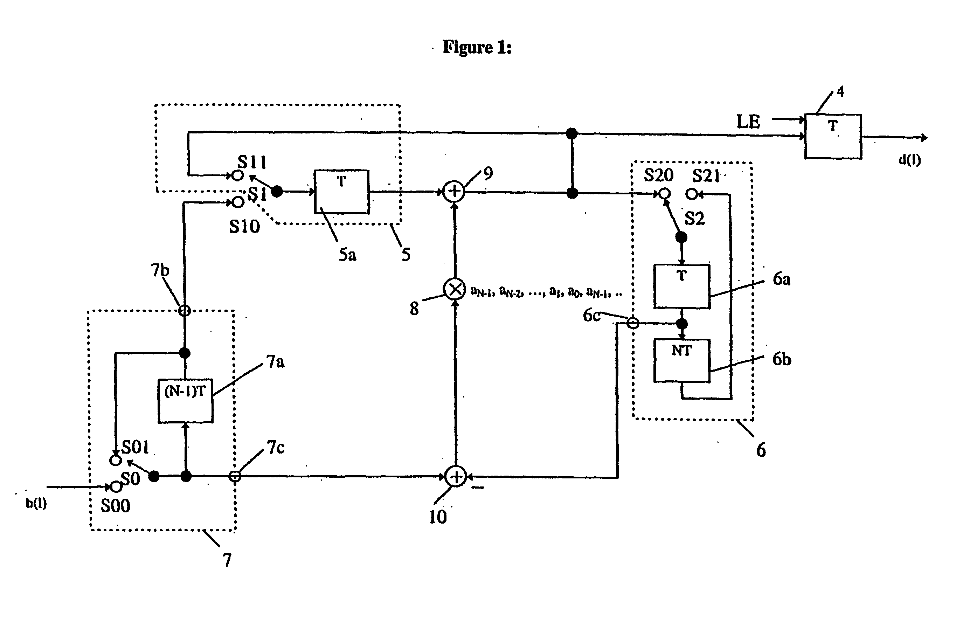

Figure 1 shows a digital allpass filter $N^{th}$ order according to a first embodiment of the present invention for filtering a real signal b(1).

This $N^{th}$ order allpass filter is realized by a modified allpass filter $1^{st}$ order that has a clock frequency $f_c$ that is N-times the sampling rate $f_S$ of the input signal b(1), i. e. $f_c = N \cdot f_S$. It works in a way that N internal intermediate results are calculated to produce an output sample of an output signal d(1). Therefore, the allpass filter according to the first embodiment of the present invention consists of a feedback loop 5, two ring buffers 6 and 7, just one multiplier 8 in which N filter coefficients get periodically switched with the clock frequency $f_c$, just one first adder 10 and one second adder 9 and one first delay element 4 to properly provide the output signal d(1). It calculates in N clock cycles $T_C$ one output sample of the allpass filter. Therefore, the allpass filter according to the first embodiment of the present invention processes in every clock cycle $T_C$ one filter coefficient $a_n$ with $0 \leq n \leq N - 1$. It follows that the modified allpass filter has N different internal states and in every internal filter state another filter coefficient is processed.

The feedback loop 5 receives every intermediate internal output value of the filter provided at the output of said second adder 9 and delays it with a second delay element 5a for one clock cycle $T_C$ to provide it as a summand to the second adder 9 to be added to the result of the next internal filter state so that after N different internal filter states all N intermediate internal output values are added up to the next output sample of the output signal d(1) of the allpass filter of order N. The summand to be added to the result of the first internal filter state is the input sample b(1-N). The ring buffer 7 provides for every internal filter state the filter input sample of the input signal b as a summand to said first adder 10 that corresponds to the respective coefficient $a_{N-1},...,a_1$, $a_0$ that gets actually processed. The other ring buffer 6 provides for every internal filter state the allpass filter output sample d as a subtrahend to said first adder 10 that corresponds to said respective coefficient $a_{N-1},..., a_0$. The output signal of said first adder 10 is provided to said multiplier 8 that switches the filter coefficient with every clock cycle $T_C$. The output signal of the multiplier 8 is provided as a summand to said second adder 9 that adds up all results of the internal filter states. The $N^{th}$ internal output value output by said adder 9 is hold at the output of the allpass filter according to the present invention by the first delay element 4 with LE. i. e. latch enable, input beginning in the state N for the next N clock cycles $T_C$. i. e. one sampling clock cycle $T_S$.

The second delay element 5a and all other delay elements described in the following are outputting one stored value and reading one value to be stored in one clock cycle $T_C$, exept for the first delay element 4 that reads one value in N clock cycles $T_C$ and holds it for N clock cycles $T_C$. The output order is the same as the input order and the total delay depends on the storing capacity of the respective delay element.

The first ring buffer 7 comprises a third delay element 7a that can store N-l1 sampling values and therefore delays all input sampling values by N-1 clock cycles $T_C$ before outputting them and an input switch S0 having a first fixed terminal S00 that receives the input signal b(1), a second fixed terminal S01 that is connected to the output of said third delay element 7a and a movable terminal that is connected to an input of said third delay element 7a and a first output 7c of said first ring buffer 7. Said movable terminal makes contact with said first fixed terminal S00 in every $N^{th}$ internal filter state and with said second fixed terminal S01 in all other internal filter states. Furtheron, said first ring buffer 7 comprises a second output 7b which is connected to the output of said third delay element 7a. Therefore, in the $N^{th}$ internal filter state a new input sample of the input signal b(1) is written to the ring buffer 7 and in all other internal filter states the stored input samples are periodically switched through.

The first output 7c of said first ring buffer 7 provides for every internal filter state the filter input sample of the filter input signal b that corresponds to the coefficient $a_{N-1},..., a_0$ that gets actually processed. It is connected to a first adder 10 so that the ring buffer 7 provides the respective filter input sample that corresponds to the coefficient $a_{N-1},...,$ $a_0$ as a first input signal to said adder 10. The output signal of said adder 10 is led to said multiplier 8 that multiplies it with the corresponding filter coefficient $a_{N-1},..., a_0$ before feeding it as a summand to a first input of a second adder 9 that provides the internal output value of said digital allpass filter $N^{th}$ order according to the first embodiment of the present invention.

The input sample b(1-N) corresponds to the "internal output value zero" when calculating the first internal output value. This sample b(1-N) is provided by said first ring buffer 7 by delaying said second output 7b by one clock cycle $T_C$. To provide this functionality, the second output 7d of said first ring buffer 7 is connected to a first fixed terminal S10 of a switch S1 that has a movable terminal connected to said second delay element 5a of said feedback loop 5. The output of said second delay element 5a is connected to a second input of said second adder 9 that provides the internal output value in every internal filter state as its output signal. Said moveable terminal of said switch S1 makes contact to said first fixed terminal S10 only in every $N^{th}$ internal filter state. In every other internal filter state said moveable terminal of said switch S1 makes contact with a second fixed terminal S11 of said switch S1 which is connected to the output of said second adder 9 and realises said feedback loop 5.

The second ring buffer 6 comprises a fourth delay element 6a that can store one sampling value and delays it by one clock period $T_C$ before outputting it having its output connected to a output 6c of said second ring buffer 6, a fifth delay element 6b that can store N sampling values and therefore delays all input sampling values by N clock periods $T_C$ before outputting them having its input connected to the output of said fourth delay element 6a, and an input switch S2 having a first fixed terminal S20 that receives each internal output value of said digital allpass filter according to the first embodiment of the present invention, a second fixed terminal S21 that is connected to an output of said fifth delay element 6b and a moveable terminal that is connected to an input of said fourth delay element 6a of said second ring buffer 6. Like the first ring buffer 7 also the second ring buffer 6 reads a new ring buffer input sample in internal filter state N. Therefore, the input switch S2 of the second ring buffer 6 switches only in the internal filter state N to the first fixed terminal S20 and in all other internal filter states to said second fixed terminal S21.

As mentioned above, the output 6c of said second ring buffer 6 is connected as second input to said first adder 10 so that all output sampling values of the second ring buffer 6 are provided as a subtrahend to said first adder 10 to be subtracted from the respective input sample also provided to said first adder 10 via the first output 7c of said first ring buffer 7.

The functionality of the ring buffers can best be explained by way of an example, e. g. for an allpass filter 3rd order, i. e. N=3. Therefore, the third delay element 7a of the first ring buffer 7 has a capacity to store N-1=3-1=2 input samples that are each delayed by N-1=3-1=2 clock cycles or clock periods $T_C$. As the filter order is chosen for this example to N=3 the digital allpass filter according to the first embodiment of the present invention has three different internal filter states that are state 1, 2 and 3. These internal filter states are existing for every filter input sample b(1) supplied to the digital allpass filter. The following table 1 shows the states of the allpass filter 3rd order according to the first embodiment of the present invention for four input samples with the corresponding coefficients $a_2$ to $a_0$, the state of the input switch S0 of the first ring buffer 7, the ring buffer output samples at the first output 7c and the second output 7b, the state of the switch S1 and the output of the second delay element 5a. Output samples of the second delay element 5a that are unimportant for the functionality of said first ring buffer are marked with dc, i.e. dont care.

Table 1

| filter input | b(0) | | | b(1) | | | b(2) | | | b(3) | | | b(4) | | |
|---|---|---|---|---|---|---|---|---|---|---|---|---|---|---|---|
| State | 1 | 2 | 3 | 1 | 2 | 3 | 1 | 2 | 3 | 1 | 2 | 3 | 1 | 2 | 3 |
| corresponding coefficient | $a_2$ | $a_1$ | $a_0$ | $a_2$ | $a_1$ | $a_0$ | $a_2$ | $a_1$ | $a_0$ | $a_2$ | $a_1$ | $a_0$ | $a_2$ | $a_1$ | $a_0$ |
| State of S0 | S01 | S0 1 | S00 | S01 | S01 | S00 | S01 | S0 1 | S00 | S01 | S0 1 | S00 | S01 | S01 | S00 |
| ring buffer output sample at first output 7c | b(-2) | b(-1) | b(0) | b(-1) | b(0) | b(1) | b(0) | b(1) | b(2) | b(1) | b(2) | b(3) | b(2) | b(3) | b(4) |
| ring buffer output sample at second output 7b | b(-2) | b(-1) | b(-2) | b(-1) | b(0) | b(-1) | b(0) | b(1) | b(0) | b(1) | b(2) | b(1) | b(2) | b(3) | b(2) |
| State of S1 | S11 | S11 | S10 | S11 | S11 | S10 | S11 | S11 | S10 | S11 | S11 | S10 | S11 | S11 | S10 |
| output of second delay element 5a | b(-3) | dc | dc | b(-2) | dc | dc | b(-1) | dc | dc | b(0) | dc | dc | b(1) | dc | dc |

It can be seen that the ring buffer provides at its first output 7c in state 1 that delayed input sample b(1-N+1). here the delayed input sample b(1-2), that must be multiplied with the coefficient $a_2$, in state 2 the delayed input sample b(1-N+2), here the delayed input sample b(1-1), that must be multiplied with the coefficient al and in state 3 the delayed input sample b(1-N+3), here the input sample b(1), that must be multiplied with the coefficient $a_0$. Furtheron, it can be seen that the first ring buffer 7 provides at its second output 7b in internal filter state 3 always the filter input sample delayed by N-1 clock periods $T_S$. i. e. the filter input sample b(1-N+1). It can also be seen that the output of the second delay element 5a provides in internal filter state 1 always the filter input sample b(1-N) which is used as the "internal output value zero".

In general, the first ring buffer 7 provides at its first output 7c in state 1 always the oldest of the N latest (stored) filter input samples, i. e. the filter input sample b(1-N+1). in state 2 the second oldest of the N latest (stored) filter input samples, i. e. the filter input sample b(1-N+2) and so on. In state N the first ring buffer 7 provides at its first output 7c the latest (newest) input sample, i. e. the filter input sample b(1).

As stated above, the second ring buffer 6 provides at its output 6c for every internal filter state the allpass filter output sample d that corresponds to the coefficient $a_{N-1},...,a_0$ that gets processed in a corresponding internal filter state. The Input switch S2 of the second ring buffer 6 switches only in the state N to the input port S20 so that in state N a new ring buffer input sample is written to the second ring buffer 6. Table 2 shows an example of the input and output samples of the second ring buffer 6 for a digital allpass filter of order N=3 according to the first embodiment of the present invention. Input samples that do not care since the moveable terminal of the input switch S2 of the second ring buffer 6 is not connected to its first fixed terminal S20 are marked by dc. The allpass filter output sample d(1) corresponds to the allpass filter input sampel b(1), i. e. is outputted when the allpass filter input sample b(1) is inputted.

Table 2

| ring buffer input sample d(1) | dc | dc | d(0) | dc | dc | d(1) | dc | dc | d(2) | dc | dc | d(3) | dc | dc | d(4) |
|---|---|---|---|---|---|---|---|---|---|---|---|---|---|---|---|
| State | 1 | 2 | 3 | 1 | 2 | 3 | 1 | 2 | 3 | 1 | 2 | 3 | 1 | 2 | 3 |
| corresponding coefficient | $a_2$ | $a_1$ | $a_0$ | $a_2$ | $a_1$ | $a_0$ | $a_2$ | $a_1$ | $a_0$ | $a_2$ | $a_1$ | $a_0$ | $a_2$ | $a_1$ | $a_0$ |
| ring buffer output sample at output 6c | d(-1) | d(-2) | d(-3) | d(0) | d(-1) | d(-2) | d(1) | d(0) | d(-1) | d(2) | d(1) | d(0) | d(3) | d(2) | d(1) |
| State of S1 | S21 | S21 | S20 | S21 | S21 | S20 | S21 | S21 | S20 | S21 | S21 | S20 | S21 | S21 | S20 |

It can be seen that the second ring buffer 6 provides in internal filter state 1 always the one sampling clock period $T_S$ delayed latest filter output sample d(1-1). in internal filter state 2 the one sampling clock period $T_S$ delayed second latest filter output sample d(1-2) and so on. In state N the second ring buffer 6 provides at its output 6c the one sampling clock period $T_S$ delayed oldest of the N latest filter output samples d(1-N).

The difference of the first ring buffer 7 and the second ring buffer 6 is that the first ring buffer 7 provides at its first output 7c in internal filter state 1 always the oldest of the N latest ring buffer input samples b(1-N+1) and the second ring buffer 6 provides in said state always the newest of the ring buffer input samples d(1-1).

From Tables 1 and 2 it can clearly be seen that for example d(4)=b(1)+$a_2$·(b(2)-d(3))+$a_1$·(b(3)-d(2))+$a_0$·(b(4)-d(1)). This corresponds to the output resulting from the state of the art digital allpass filter 3$^{rd}$ order shown in figure 9 and its transfer function defined in formula 2.

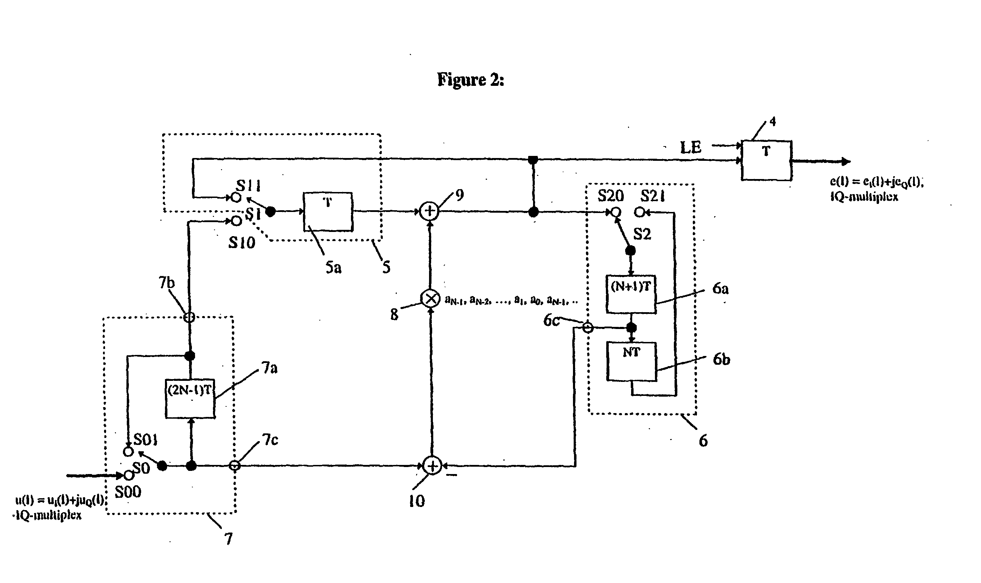

Figure 2 shows a second embodiment of the digital allpass filter N$^{th}$order according to the present invention that is adapted for the filtering of complex signals. The shown filter replaces the demultiplexer 51, both filters 52a and the multiplexer 53 of the circuit shown in figure 7. Therefore, the filter input signal u(1) is the multiplex of the inphase and quadrature component of a complex signal.

$$u(1)=u_I(1)+ju_Q(1), \text{ multiplexed}$$

The digital allpass filter N$^{th}$ order according to the second embodiment of the present invention shown in figure 2 processes the inphase and the quadrature component of the complex signal u(1) in one sampling clock period $T_S$. Therefore, the digital filter N$^{th}$ order according to the second embodiment of the present invention has 2·N different internal states, i. e. N internal filter states for the calculation of the filtered inphase component and N different internal filter states for the calculation of the filtered quadrature component. Therefore, the clock frequency $f_c$ of this embodiment has to be chosen to $f_c$=2·N·$f_S$.

Apart from the different clock frequency $f_c$ the differences in between the first and the second embodiments of the present invention are that the third delay element 7a of the first ring buffer 7 can now store 2N-1 input samples and delays all input samples respectively for 2N-1 clock periods $T_C$. the moveable terminal of the input switch S0 of the first ring buffer 7 switches to its first fixed terminal S00 every N$^{th}$ and every 2N$^{th}$ internal filter state and to its second fixed terminal S01 in all other internal filter states, the moveable terminal of the switch S1 switches to its first fixed terminal S10 also every N$^{th}$ and 2N$^{th}$ internal filter state and to its second fixed terminal S11 in all other internal filter states, the fourth delay element 6a of the second ring buffer 6 can store N+1 input samples and delays them respectively for N+1 clock periods $T_C$ and the moveable terminal of the input switch S2 of the second ring buffer 6 makes contact to its first fixed terminal S20 in every N$^{th}$ and every 2N$^{th}$ internal filter state and to its second fixed terminal S21 in all other Internal filter states. Also, the first delay element 4 holds the N$^{th}$ and the 2N$^{th}$ internal filter states with LE (latch enable) input respectively for the next N clock periods $T_C$. i. e. one half sampling clock period $T_S$.

In the second embodiment also N different filter coefficients $a_{N-1}$,..., $a_0$ are switched to process one of these filter coefficients in every internal filter state. Therefore, within one sampling clock period $T_S$ every filter coefficient will be needed twice, once for the calculation of the inphase component and once for the calculation of the quadrature component.

Although the modified allpass filter consists again of the feedback loop 5 and two ring buffers 6 and 7 it realizes two allpass filters of order N as shown in figures 7 and 8, i. e. one for the inphase component and one for the quadrature component. The digital allpass filter N$^{th}$ order for complex signals according to the second embodiment of the present invention processes in the first N cycles the inphase component of the complex input signal $u_I(1)$ and in the next N cycles the quadrature component $u_Q(1)$ of the complex input signal to calculate in 2N clock cycles $T_C$ one complex output sample e(1)=$e_I(1)$+$je_Q(1)$. It has different ring buffers 6 and 7 and works with a different clock frequency $f_c$ than the digital allpass filter according to the first embodiment of the present invention, but it is also realized with only two adders and one multiplier.

As the second embodiment of the present invention basically works as the first embodiment of the present invention described above and there are only small differences in between the first and the second embodiment an in-depth description of the second embodiment can be omitted.

In the first N clock periods $T_C$ the feedback loop 5 adds the one clock period $T_C$ delayed output sample of the second output 7b of the first ring buffer 7 in internal filter state 1, i. e. $u_I(1N)$, and the N output samples of the coefficient multiplication of the inphase component up to the inphase component $e_I(1)$ of the complex output signal e(1)=$e_I(1)$+$je_Q$(1) of the digital allpass filter N$^{th}$ order according to the second embodiment of the present invention. In the next N clock cycles $T_C$ the feedback loop 5 performs the same operation for the quadrature component $e_Q(1)$ of the complex allpass filter output signal e(1). As stated above, to perform this operation the switch S1 switches in internal filter states N and 2N to its first fixed terminal S10 and in all other states to its second fixed terminal S11. The output samples $e_I$(1) and $e_Q(1)$ of the feedback loop are hold at the output of the digital allpass filter N$^{th}$ order according to the second embodiment of the present invention by the first delay element 4 with LE input beginning in state N and 2N for the next N clock cycles.

The first ring buffer 7 provides for every internal filter state the respective filter input sample that corresponds to one of the filter coefficients $a_{N-1},..., a_0$. Therefore, the input switch S0 of the ring buffer switches in states N and 2N to its first fixed terminal S00 so that in state N the inphase component $u_I(1)$ of the multiplexed complex input signal u(1) is written into the first ring buffer 7 and in state 2N the quadrature component $u_Q(1)$ of the complex input signal u(1) is written into the first ring buffer 7.

As explained above in connection with the first embodiment according to the present invention, i. e. the digital allpass filter $N^{th}$ order for real signals, the first ring buffer 7 according to the second embodiment of the present invention will also be explained by way of an example with a digital allpass filter $3^{rd}$ order for complex signals. Therefore, the digital allpass filter has 2N=2·3=6 different internal states, here state 1, 2, 3, 4, 5 and 6. The following table 3 shows the filter input samples u(1), the internal filter state, the corresponding filter coefficient to be processed, the state of the input switch S0 of the first ring buffer 7, the ring buffer output sample at the first output 7c and at the second output 7b, the state of the switch S1 and the output sample of the ssecond delay element 5a.

The first ring buffer 7 provides at its first output 7c in state 1 always the inphase sample $u_I(1-N+1)$ of the N latest inphase filter input samples and in state N+1 the oldest quadrature sample $u_Q(1-N+1)$ of the N latest quadrature filter input samples, in state 2 always the second oldest inphase sample $u_I(1-N+2)$ of the N latest filter inphase samples and in state N+2 the second oldest quadrature sample $u_Q(1-N+2)$ of the N latest quadrature filter input samples and so forth.

The second output 7b of the first ring buffer 7 provides in state N always the filter input sample $u_Q(1-N)$, in the above example $u_Q(1-3)$, and in state 2N the filter input sample $u_I(1-N+1)$, in the above example $u_I(1-2)$. This output signals are delayed by the second delay element 5a by one clock cycle $T_C$ so that the output of the second delay element 5a provides in internal filter state 1 always the filter input sample $u_I(1-N)$ and in state N+1 always the filter input sample $u_Q(1-N)$ which are used as the "internal output values zero".

| filter input sample u(l) | $u_I(0)$ | | | $u_Q(0)$ | | | $u_I(1)$ | | | $u_Q(1)$ | | |
|---|---|---|---|---|---|---|---|---|---|---|---|---|
| State | 1 | 2 | 3 | 4 | 5 | 6 | 1 | 2 | 3 | 4 | 5 | 6 |
| corresponding coefficient | $a_2$ | $a_1$ | $a_0$ | $a_2$ | $a_1$ | $a_0$ | $a_2$ | $a_1$ | $a_0$ | $a_2$ | $a_1$ | $a_0$ |
| State of S0 | S01 | S01 | S00 | S01 | S01 | S00 | S01 | S01 | S00 | S01 | S01 | S00 |
| ringbuffer output sample at first output 7c | $u_I(-2)$ | $u_I(-1)$ | $u_I(0)$ | $u_Q(-2)$ | $u_Q(-1)$ | $u_Q(0)$ | $u_I(-1)$ | $u_I(0)$ | $u_I(1)$ | $u_Q(-1)$ | $u_Q(0)$ | $u_Q(1)$ |
| ring buffer output sample at second output 7b | $u_I(-2)$ | $u_I(-1)$ | $u_Q(-3)$ | $u_Q(-2)$ | $u_Q(-1)$ | $u_I(-2)$ | $u_I(-1)$ | $u_I(0)$ | $u_Q(-2)$ | $u_Q(-1)$ | $u_Q(0)$ | $u_I(-1)$ |
| State of S1 | S11 | S11 | S10 | S11 | S11 | S10 | S11 | S11 | S10 | S11 | S11 | S10 |
| output of second delay element 5a | $u_I(-3)$ | dc | dc | $u_Q(-3)$ | dc | dc | $u_I(-2)$ | dc | dc | $u_Q(-2)$ | dc | dc |

| filter input sample u(l) | $u_I(2)$ | | | $u_Q(2)$ | | | $u_I(3)$ | | | $u_Q(3)$ | | |
|---|---|---|---|---|---|---|---|---|---|---|---|---|
| State | 1 | 2 | 3 | 4 | 5 | 6 | 1 | 2 | 3 | 4 | 5 | 6 |
| corresponding coefficient | $a_2$ | $a_1$ | $a_0$ | $a_2$ | $a_1$ | $a_0$ | $a_2$ | $a_1$ | $a_0$ | $a_2$ | $a_1$ | $a_0$ |
| State of S0 | S01 | S01 | S00 | S01 | S01 | S00 | S01 | S01 | S00 | S01 | S01 | S00 |
| ringbuffer output sample at first output 7c | $u_I(0)$ | $u_I(1)$ | $u_I(2)$ | $u_Q(0)$ | $u_Q(1)$ | $u_Q(2)$ | $u_I(1)$ | $u_I(2)$ | $u_I(3)$ | $u_Q(1)$ | $u_Q(2)$ | $u_Q(3)$ |
| ring buffer output sample at second output 7b | $u_I(0)$ | $u_I(1)$ | $u_Q(-1)$ | $u_Q(0)$ | $u_Q(1)$ | $u_I(0)$ | $u_I(1)$ | $u_I(2)$ | $u_Q(0)$ | $u_Q(1)$ | $u_Q(2)$ | $u_I(1)$ |
| State of S1 | S11 | S11 | S10 | S11 | S11 | S10 | S11 | S11 | S10 | S11 | S11 | S10 |
| output of second delay element 5a | $u_I(-1)$ | dc | dc | $u_Q(-1)$ | dc | dc | $u_I(0)$ | dc | dc | $u_Q(0)$ | dc | dc |

**Table 3**

The second ring buffer 6 provides in internal filter state 1 always the one sampling clock period $T_S$ delayed latest filter output sample $e_I(1\text{-}1)$ and in state N+1 the one sampling clock period $T_S$ delayed latest quadrature filter output sample $eg(1\text{-}1)$, in state 2 always the one sampling clock period $T_S$ delayed second latest inphase filter output sample $e_I(1\text{-}2)$ and in internal filter state N+2 the one sampling clock period $T_S$ delayed second latest quadrature filter output sample $eg(1\text{-}2)$ and so on. Therefore, the input switch S2 of the second ring buffer 6 switches in states N and 2N to its fixed terminal S20 so that in state N the inphase component $e_I(1)$ of the multiplexed complex allpass filter output signal $e(1)$ is written into the second ring buffer 6 and in state 2N the quadrature component $e_Q(1)$ is written into the second ring buffer 6. In all other internal filter states the input switch S2 of the second ring buffer 6 switches to its second fixed terminal S21.

Table 4 shows an example for the input and output samples of the second ring buffer 6 and the state of its input switch S2 in every internal filter state for a plurality of ring buffer input samples $e(1)=e_I(1)+je_Q(1)$, i. e. filter output samples $e(1)$. Ring buffer input samples that do not care, since the moveable terminal of the input switch S2 is connected to its second fixed terminal S21 are marked by dc.

| ring buffer input sample e(l) | dc | dc | $e_I(0)$ | dc | dc | $e_Q(0)$ | dc | dc | $e_I(1)$ | dc | dc | $e_Q(1)$ |
|---|---|---|---|---|---|---|---|---|---|---|---|---|
| State | 1 | 2 | 3 | 4 | 5 | 6 | 1 | 2 | 3 | 4 | 5 | 6 |
| corresponding coefficient | $a_2$ | $a_1$ | $a_0$ | $a_2$ | $a_1$ | $a_0$ | $a_2$ | $a_1$ | $a_0$ | $a_2$ | $a_1$ | $a_0$ |
| ring buffer output sample at output 6c | $e_I(-1)$ | $e_I(-2)$ | $e_I(-3)$ | $e_Q(-1)$ | $e_Q(-2)$ | $e_Q(-3)$ | $e_I(0)$ | $e_I(-1)$ | $e_I(-2)$ | $e_Q(0)$ | $e_Q(-1)$ | $e_Q(-2)$ |
| State of S2 | S21 | S21 | S20 | S21 | S21 | S20 | S21 | S21 | S20 | S21 | S21 | S20 |

| ring buffer input sample e(l) | dc | dc | $e_I(2)$ | dc | dc | $e_Q(2)$ | dc | dc | $e_I(3)$ | dc | dc | $e_Q(3)$ |
|---|---|---|---|---|---|---|---|---|---|---|---|---|
| State | 1 | 2 | 3 | 4 | 5 | 6 | 1 | 2 | 3 | 4 | 5 | 6 |
| corresponding coefficient | $a_2$ | $a_1$ | $a_0$ | $a_2$ | $a_1$ | $a_0$ | $a_2$ | $a_1$ | $a_0$ | $a_2$ | $a_1$ | $a_0$ |
| ring buffer output sample at output 6c | $e_I(1)$ | $e_I(0)$ | $e_I(-1)$ | $e_Q(1)$ | $e_Q(0)$ | $e_Q(-1)$ | $e_I(2)$ | $e_I(1)$ | $e_I(0)$ | $e_Q(2)$ | $e_Q(1)$ | $e_Q(0)$ |
| State of S2 | S21 | S21 | S20 | S21 | S21 | S20 | S21 | S21 | S20 | S21 | S21 | S20 |

**Table 4**

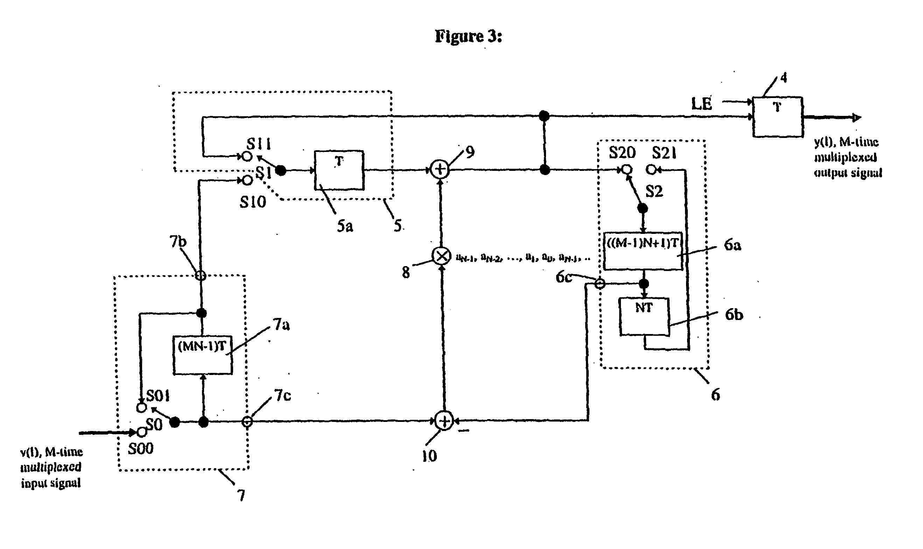

Figure 3 shows the realization of an allpass filter Nth order for multiplexed signals with higher multiplex order than 2 according to a third embodiment of the present invention. The multiplex order M is M=1 for real signals and M=2 for complex signals. Figure 3 shows an allpass realization for $M^{th}$ order multiplexed signals.

The clock frequency $f_c$ is defined by M N times the sampling frequency $f_s$, i.e. $f_c = M \cdot N \cdot f_s$. Therefore, the filter has $M \cdot N$ internal filter states.

Apart from the different clock frequency $f_c$ the differences in between the second and the third embodiments of the present invention are that the third delay element 7a of the first ring buffer 7 can now store MN-1 input samples and delays all input samples respectively for MN-1 clock periods $T_C$, the moveable terminal of the input switch S0 of the first ring buffer 7 switches to its first fixed terminal S00 every $N^{th}$, $2N^{th}$, ... and every $MN^{th}$ internal filter state and to its second fixed terminal S01 in all other internal filter states, the moveable terminal of the switch S1 switches to its first fixed terminal S10 also every $N^{th}$, $2N^{th}$, ... and every $MN^{th}$ internal filter state and to its second fixed terminal S11 in all other internal filter states, the fourth delay element 6a of the second ring buffer 6 can store (M-1)N+1 input samples and delays them respectively for (M-1)N+1 clock periods $T_C$ and the moveable terminal of the input switch S2 of the second ring buffer 6 makes contact to its first fixed terminal S20 in every $N^{th}$, $2N^{th}$, ... and every $MN^{th}$ internal filter state and to its second fixed terminal S21 in all other internal filter states. Like in the first and second embodiments, the coefficients are switched beginning from internal filter state 1 in the order $a_{N-1}$, $a_{N-2}$, ..., $a_1$, $a_0$, $a_{N-1}$ $a_{N-2}$,.... Also, the first delay element 4 holds the $N^{th}$, $2N^{th}$,... and every $MN^{th}$ internal filter states with LE (latch enable) input respectively for the next N clock cycles $T_C$, i. e. one $M^{th}$ sampling clock period $T_S$.

As the third embodiment of the present invention basically works as the second embodiment of the present invention described above and there are only small differences in between the second and the third embodiments an in-depth description of the third embodiment can be omitted.

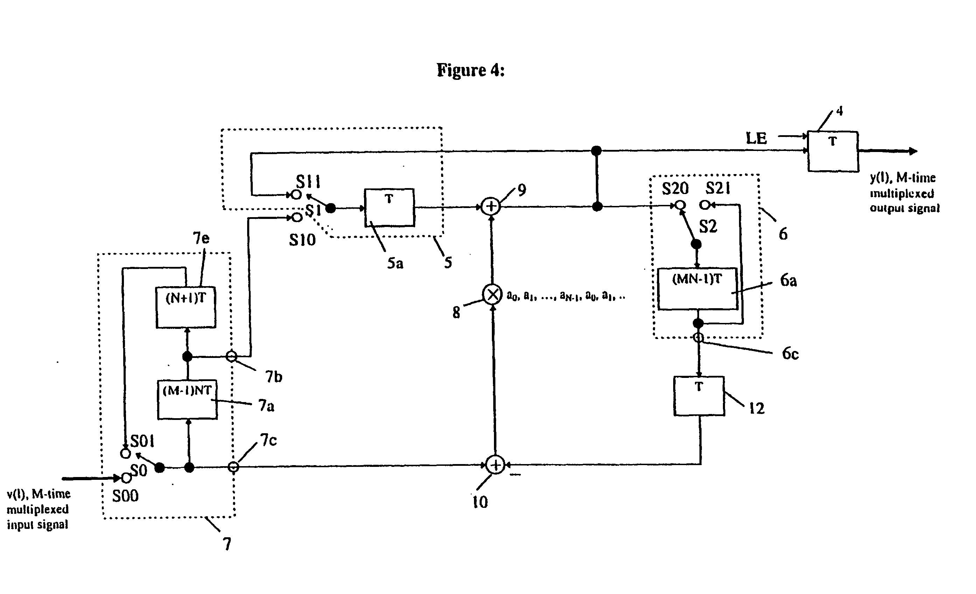

Figure 4 shows an alternative realization of an allpass filter $N^{th}$ order according a fourth embodiment of to the present Invention. The difference in-between the realization shown in figure 3 and the alternative realization of figure 4 is that the structure of the second ring buffer 6 shown in figure 3 is replaced by the structure and delay characteristics of the first ring buffer 7 of figure 3 with the first output 7c being omitted, i. e. the fifth delay element 6b in the path between the ouput of the fourth delay element 6a and the second fixed terminal S21 off the input switch D2 of the second ring buffer 6 being omitted, in other words the second ring buffer 6 now only comprises the fourth delay element 6a, which can now store (MN-1) sampling values, and the first ring buffer 7 has a structure wherein a sixth delay element 7e which can store (N+1) input samples is provided in the path between the output of the third delay element 7a and the second fixed terminal S01 of the input switch S0 of the first ring buffer 7.

The first ring buffer 7 therewith shows modified delay times and capacities of the delay elements and modified outputs. The first ring buffer 7 comprises the third delay element 7a that can now store (M-1)N sampling values and respectively delays them by (M-1)N clock periods $T_C$ before outputting them having its output connected to the second output 7b of said first ring buffer 7, the sixth delay element 7e that can store N+1 sampling values and therefore delays all input sampling values by N+1 clock periods $T_C$ before outputting them having its input connected to the output of said third delay element 7a, and the input switch S0 with the first fixed terminal S00 that receives each input value to said digital allpass filter according to the fourth embodiment of the present invention, the second fixed terminal S01 that is connected to an output of said sixth delay element 7e and the moveable terminal that is connected to the input of said third delay element 7a of said first ring buffer 7 and the first output 7c of said first ring buffer 7.

In this alternative allpass realization, an additional seventh delay element 12 having a delay time of one clock cycle $T_C$ must be placed between the output 6c of the second ring buffer 6 and the first adder 10. So the realization costs are increased compared to the allpass realization shown in figure 3.

Due to the different structure of the first ring buffer 7 and the second ring buffer 6 the order of the coefficient multiplication has to be changed as well. Unlike in the first three embodiments, the coefficients are switched beginning from internal filter state 1 in the order $a_0$, $a_1$, ..., $a_{N-2}$, $a_{N-1}$, $a_0$, $a_1$, ....

As in the third embodiment of the present invention, the clock frequency $f_c$ is defined by $M \cdot N$ times the sampling frequency $f_s$, i.e. $f_c = M \cdot N \cdot f_s$. Therefore, the filter also has M N internal filter states.

The moveable terminal of the input switch S2 switches to its first fixed terminal S20 every $N^{th}$, $2N^{th}$, ... and every $MN^{th}$ internal filter state and to its second fixed terminal S21 in all other internal filter states, the moveable terminal of the switch S1 switches to its first fixed terminal S10 also every $1^{st}$, $(N+1)^{th}$, $(2N+1)^{th}$ ... and every $((M-1)N+1)^{th}$ internal filter state and to its second fixed terminal S11 in all other internal filter states and the moveable terminal of the input switch S0 makes contact to its first fixed terminal S00 in every $N^{th}$, $2N^{th}$, ... and every $MN^{th}$ internal filter state and to its second fixed terminal S01 in all other internal filter states. Also, the first delay element 4 holds the $N^{th}$, $2N^{th}$, ... and every $MN^{th}$ internal filter states with LE (latch enable) input respectively for the next N clock cycles $T_C$, i. e. one $M^{th}$ sampling clock period $T_S$.

As the fourth embodiment of the present invention basically works as the third embodiment of the present invention described above and there are only small differences in between the fourth and the third embodiments an in-depth description of the fourth embodiment can be omitted.

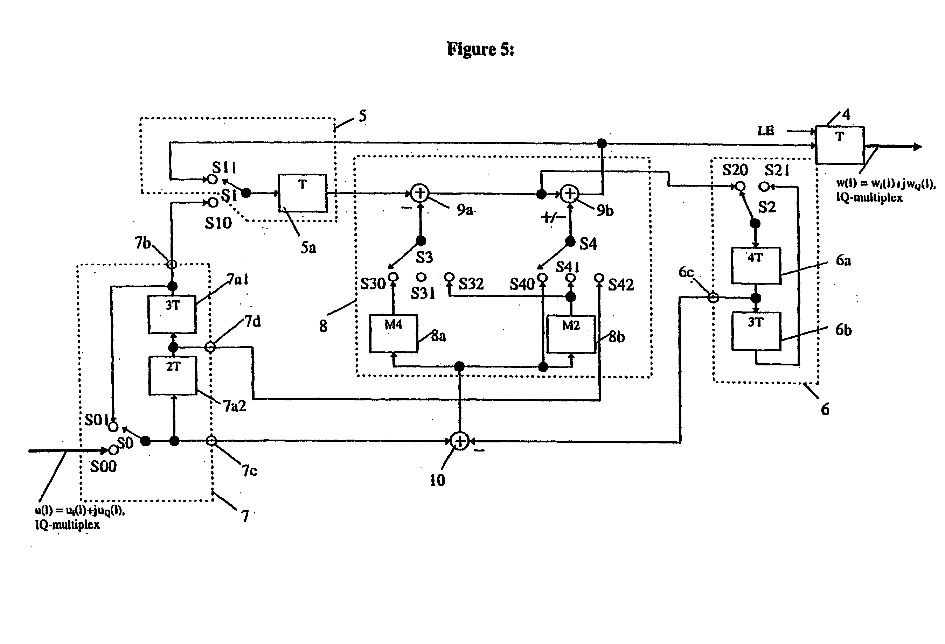

Figure 5 shows a digital filter $3^{rd}$ order for a complex input signal according to a fifth embodiment of the present invention. According to the fifth embodiment of the present invention it is possible to change the transfer function of the allpass filter for complex signals by changing the coefficient set $a_n$, $0 \leq n \leq N-1$, to another coefficient set $\bar{a}_n$, $0 \leq n \leq N-1$ without additional realization costs. In the shown example the transfer function of the digital allpass filter can be switched between lowpass and highpass mode. This lowpass/highpass filter consists of a parallel connection of a 3rd order allpass filter for complex signals as described in the second embodiment of the present invention, see figure 2. and 2nd order delay elements, as it is shown in figure 7. Therefore, the digital filter according to the fifth embodiment of the present invention can replace the whole circuitry shown in figure 7.

For the reason of the parallel connection of the digital allpass filter and the delay elements of order N-1 the first ring buffer 7 comprises a modified third delay element 7a with first sub delay element 7a1 and a second sub delay element 7a2. The second sub delay element 7a2 has the order N-1 and the first sub delay element 7a1 has the order N so that in total a order 2N-1 is achieved, i. e. the order of the third delay element 7a of the first ring buffer 7 according to the second embodiment of the present invention. Therefore, by only inserting a tap at a predetermined position in the third delay element 7a of the first ring buffer 7 a third output 7d of the first ring buffer 7 is created to realize the parallel connection of the digital allpass filter with the delay element to design a lowpass or highpass filter. Therefore, nearly no additional realization costs are generated for the realization of a highpass or lowpass filter with the help of an allpass filter according to the present invention. The output samples of the third output 7d have to be combined with the output of the digital allpass filter to achieve a digital lowpass or highpass filter, e. g. both outputs have to be added to realize a lowpass filter or the output samples of the third output 7d have to be subtracted from the output of the digital allpass filter to realize a highpass filter.

In the example shown in figure 5 the coefficients $a_0$, $a_1$, $a_2$ of the allpass filter are designed in a way that the resulting lowpass filter of the parallel connection of the allpass filter and the delay element performs the nearby selectivity of a complex DAB-baseband signal, as it is explained in the example shown in figure 6. The filter has an almost linear phase response in the passband and a neighbour channel suppression of more than 42dB. The coefficients are quantized in a way that they can be realized easily by shift and add operations. The coefficient set $a_0$, $a_1$, $a_2$ for lowpass filter mode is listed in table 5.

Table 5

| $a_0$ | $a_1$ | $a_2$ |
|---|---|---|
| - 0,25 | 0,25 | 0,9375 |

In highpass filter mode the coefficients of the allpass filter $\bar{a}_0$, $\bar{a}_1$, $\bar{a}_2$ are designed in the way that an anti-aliazing filter for the sampling rate decimation of a frequency modulated broadcast signal is achieved. The filter has an almost linear phase response in the passband. The coefficients are quantisized in a way that can be realized with the same hardware elements that are needed for the realization of the coefficient set $a_0$, $a_1$, $a_2$ for the lowpass filter mode. The coefficient set $\bar{a}_0$, $\bar{a}_1$, $\bar{a}_2$ for the highpass filter mode is listed in table 6:

Table 6

| $\bar{a}_0$ | $\bar{a}_1$ | $\bar{a}_2$ |
|---|---|---|
| -0,0625 | 0,25 | 0,75 |

These two different coefficient sets are realized by shift and add/sub operations.

By splitting the second adder 9 into two adders 9a and 9b to realize the coefficient sets by shift and add/sub operations, the lowpass/highpass filter for complex signals consisting of a parallel connection of allpass filters and delay elements shown in figure 7 is realized by a moveable connection of the output 7d of the first ring buffer 7 with the input of the second adder 9b.

The coefficient sets are realized with the switches S3 and S4 respectively having a moveable terminal and 3 fixed terminals and two shift registers 8a and 8b one having a shift value 2 and the other one a shift value 4. The output of the first adder 10 is connected to the first shift register 8a having the shift value 4 which is connected to the first fixed terminal S30 of the first selection switch S3. The output of the first adder 10 is furtheron connected to the first fixed terminal S40 of the second selection switch S4 and the second shift register having a shift value 2 which is connected to the second fixed terminal S41 of the second selection switch S4 and the third fixed terminal S32 of the first selection switch S3. Furtheron, the third output 7d of the first ring buffer 7 is connected to the third fixed terminal S42 of the second selection switch S4. The second adder 9a is connected to the output of the second delay element 5a and the moveable terminal of the first selection switch S3 with the signals coming from the first selection switch S3 being subtracted from the signals coming from the second delay element 5a. The output signal of this second adder 9a is the input of the third adder 9b from which the output signals of the second selection switch S4 are subtracted or to which they are added. The resulting signal, i. e. the output signal of the third adder 9b, is fed to the first delay element 4 and the feedback loop 5. The output of the second adder 9a is also input to the second ring buffer 6.

The second shift register 8b performs a shift with the shift value 2, this corresponds to a multiplication with the factor $2^{-2}=0,25$. In the same way the first shift register 8a performs a shift with the shift value 4 which corresponds to a multiplication with the factor $2^{-4}=0,0625$.

The coefficient set $a_0$, $a_1$, $a_2$ for lowpass mode and the coefficient set $\bar{a}_0$, $\bar{a}_1$, $\bar{a}_2$ for highpass mode are realized by shift and add operations with the two shift registers 8a and 8b and the selection switches S3 and S4. Additionally, the second selection switch S4 switches in states N, here in state 3, to the delayed input sample $u_I(1-N+1)$, here $u_I(1-2)$ and in internal filter state 2N, here in internal filter state 6, to the delayed input sample $u_Q(1-N+1)$, here $u_Q(1-2)$. so that the N-1 samples delayed input signals $u_I(1-N+1)$ and $u_Q(1-N+1)$, here the 2 samples delayed input signals $u_I(1-2)$ and $u_Q(1-2)$, are added/subtracted to the output of the two allpass filters for the inphase and quadrature component. So the structure shown in figure 5 realizes two real lowpass/highpass filters consisting of the parallel connection of a 3rd order allpass filter and a 2nd order delay element as it is shown In figure 7.

Table 7 shows the state of all switches S0, S1, S2, S3, S4, the latch enable of the first delay element 4 with LE input and the state of the third adder 9b which can be switched between add- and sub-mode for every of the 2N=6 different internal filter states. The latch enable of the first delay element 4 is active high as in the embodiments described before.

Table 7

| State | 1 | 2 | 3 | 4 | 5 | 6 |
|---|---|---|---|---|---|---|
| S0 | 1 | 1 | 0 | 1 | 1 | 0 |
| S1 | 1 | 1 | 0 | 1 | 1 | 0 |
| S2 | 1 | 1 | 0 | 1 | 1 | 0 |
| S3 | 0 | 1 | 2 | 0 | 1 | 2 |
| S4 | 0 | 1 | 2 | 0 | 1 | 2 |
| LE | 0 | 0 | 1 | 0 | 0 | 1 |
| +/- | add | add | add | add | add | add |

The same is shown in case of highpass mode in table 8:

Table 8

| State | 1 | 2 | 3 | 4 | 5 | 6 |
|---|---|---|---|---|---|---|
| S0 | 1 | 1 | 0 | 1 | 1 | 0 |
| S1 | 1 | 1 | 0 | 1 | 1 | 0 |
| S2 | 1 | 1 | 0 | 1 | 1 | 0 |
| S3 | 2 | 1 | 0 | 2 | 1 | 0 |
| S4 | 0 | 1 | 2 | 0 | 1 | 2 |
| LE | 0 | 0 | 1 | 0 | 0 | 1 |
| +/- | add | add | sub | add | add | sub |

Of course, such a modification of the allpass filter to directly realize a lowpass or highpass filter or to realize one of the filters mentioned above with or without a switchable set of coefficients is also possible with the digital allpass filter according to the first, third and fourth embodiment of the present invention.

**Claims**

1. Digital filter of order N receiving a M-times multiplexed input signal (b(1); u(1); v(1)) with a sampling rate ($f_S$) and outputting a M-times multiplexed output signal (d(1); e(1); y(1)) with said sampling rate ($f_S$). comprising a modified filter of order 1 in which N filtercoefficients ($a_n$, $0 \leq n \leq N-1$) get periodidically switched with a clock frequency ($f_C$) that equals to M·N-times said sampling rate ($f_S$) to set the filter periodically into M·N internal filter states in each of which an internal output value is calculated before outputting one complete sample of the M-times multiplexed output signal (d(1); e(1); y(1)), **characterized by**

> a first ringbuffer (7) receiving the input signal (b(1); u(1); v(1)) with said sampling rate ($f_S$) and respectively outputting the corresponding input samples needed to calculate an internal filter state with said clock frequency ($f_c$); and
> a second ringbuffer (6) receiving the internal output values of the filter in every internal filter state and respectively outputting the corresponding internal output value needed to calculate a next internal filter state with said clock frequency ($f_c$).

2. Filter according to claim 1, **characterized in that** each $\underline{a}N^{th}$ internal output value, $\underline{a}$ represents all positive integers with $0<\underline{a}<M$, represents one sample of the output signal (d(1); e(1); y(1)).

3. Filter according to claim 1 or 2, **characterized by** a feedback loop (5) receiving the internal output value of the filter in every internal filter state, delaying it by one clock period ($T_C$) of said clock frequency ($f_c$) and outputting it for the calculation of the next internal output value.

4. Filter according to anyone of claims 1 to 3, **characterized by** a first delay element (4) holding every $\underline{a}N^{th}$ internal output value, $\underline{a}$ represents all positive integers with $0<\underline{a}\leq M$, of the filter for a period of N clock periods ($T_C$) of said clock frequency ($f_c$) to output the output signal (d(1); e(1); y(1)).

5. Filter according to anyone of claims 1 to 4, **characterized in that** said first ringbuffer (7) comprises

> a third delay element (7a) that can store MN-1 sampling values and delays all input sampling values by MN-1 sampling periods ($T_S$) of said sampling rate ($f_S$) before outputting them;
> an input switch (S0) having a first fixed terminal (S00) that receives the input signal (b(1); u(1); v(1)), a second fixed terminal (S01) that is connected to an output of said third delay element (7a) and a moveable terminal that is connected to an input of said third delay element (7a) and a first output (7c) of said first ringbuffer (7), wherein said moveable terminal is connected with said first fixed terminal (S00) in every $\underline{a}N^{th}$ internal filter state, $\underline{a}$ represents all positive Integers with $0<\underline{a}\leq M$, and with said second fixed terminal (S01) in all other internal filter states; and
> a second output (7b) that is connected to the output of said third delay element (7a).

6. Filter according to claim 5, **characterized in that**

> said first ringbuffer (7) comprises a third output (7d) connected to a tap of said third delay element (7a) providing a N-1 clock periods ($T_C$) of said clock frequency ($f_c$) delayed input sampling value, and by
> an adder/subtracter provided to add or subtract the samples output from said third output (7d) of said first ringbuffer to/from every $\underline{a}N^{th}$ internal output value to realize a lowpass or highpass filter, $\underline{a}$ represents all positive integers with $0<\underline{a}\leq M$.

7. Filter according to claim 6, **characterized in that** said third delay element (7a) comprises

> a first sub delay element (7a1) that can store (M-1)N sampling values and delays all input sampling values by (M-1)N clock periods ($T_C$) of said clock frequency ($f_c$) before outputting them having its input connected to said third output (7d) of said first ringbuffer (7) and its output connected to said second output (7b) of said first ringbuffer (7), and
> a second sub delay element (7a2) that can store N-1 sampling values and delays all input sampling values by N-1 clock periods ($T_C$) of said clock frequency ($f_c$) before outputting them having its input connected to said first output (7c) of said first ringbuffer (7) and its output connected to said third output (7d) of said first ringbuffer (7).

8. Filter according to anyone of claims 1 to 7, **characterized in that** said second ringbuffer (6) comprises

> a fourth delay element (6a) that can store (M-1)N+1 sampling values and delays all input sampling values by (M-1)N+1 clock periods ($T_C$) of said clock frequency ($f_c$) before outputting them having its output connected to a output (6c) of said second ringbuffer (6);
> a fifth delay element (6b) that can store N sampling values and delays all input sampling values by N clock periods ($T_C$) of said clock frequency ($f_c$) before outputting them having its input connected to the output of said fourth delay element (6a); and

a switch (S2) having a first fixed terminal (S20) that receives the internal output value, a second fixed terminal (S21) that is connected to an output of said fifth delay element (6b) and a moveable terminal that is connected to an input of said fourth delay element (6a), wherein said moveable terminal is connected with said first fixed terminal (S20) in every $\underline{a}N^{th}$ internal filter state, $\underline{a}$ represents all positive integers with $0<\underline{a}\leq M$. and with said second fixed terminal (S21) in all other internal filter states.

9. Filter according to anyone of claims 1 to 4, **characterized in that** said first ringbuffer (7) comprises

a third delay element (7a) that can store (M-1)N sampling values and delays all input sampling values by (M-1)N clock periods ($T_C$) of said clock frequency ($f_c$) before outputting them;

a sixth delay element (7e) that can store N+1 sampling values and delays all input sampling values by N+1 clock periods ($T_C$) of said clock frequency ($f_c$) before outputting them having its input connected to the output of said third delay element (7a);

an input switch (S2) having a first fixed terminal (S20) that receives the input signal (v(1)), a second fixed terminal (S21) that is connected to an output of said sixth delay element (7e) and a moveable terminal that is connected to an input of said third delay element (7a) and a first output (11c) of said first ringbuffer (11), wherein said moveable terminal is connected with said first fixed terminal (S20) in every $((\underline{a}-1)N+1)^{th}$ internal filter state, $\underline{a}$ represents all positive integers with $0<\underline{a}\leq M$, and with said second fixed terminal (S21) in all other internal filter states; and

a second output (11b) that is connected to the output of said third delay element (7a).

10. Filter according to anyone of claims 1 to 4 or 9, **characterized in that** said second ringbuffer (6) comprises

a fourth delay element (6a) that can store MN-1 sampling values and delays all input sampling values by MN-l clock periods ($T_C$) of said clock frequency ($f_c$) before outputting them having its output connected to a output (7b) of said second ringbuffer (7); and

a switch (S0) having a first fixed terminal (S00) that receives the internal output value, a second fixed terminal (S01) that is connected to the output of said fourth delay element (6a) and a moveable terminal that is connected to an input of said fourth delay element (6a), wherein said moveable terminal is connected with said first fixed terminal (S00) in every $\underline{a}N^{th}$ internal filter state, $\underline{a}$ represents all positive integers with $0<\underline{a}\leq M$, and with said second fixed terminal (S01) in all other internal filter states; and **in that**

said output (7b) of said second ringbuffer (7) is directly connected to a seventh delay element (12) that can store one sampling value and delays all input samples by one clock period ($T_C$) of said clock frequency ($f_c$) .

11. Filter according to anyone of claims 1 to 10, **characterized by**

a first adder (10) receiving a $k^{th}$ first ringbuffer (7) output sample, $O<k\leq MN$, and a $k^{th}$ second ringbuffer (6) output sample to output the difference inbetween said $k^{th}$ first ringbuffer (7) output sample and said $k^{th}$ second ringbuffer (6) output sample;

a multiplier (8) receiving the difference inbetween said $k^{th}$ first ringbuffer (7) output sample and said $k^{th}$ second ringbuffer (6) output sample calculated by said first adder (10) and multiplying it with a corresponding one of said N filter coefficients ($a_n$, $0\leq n\leq N-1$) that get periodidically switched with said clock frequency ($f_c$); and

a second adder (9) receiving the N samples of the sampling rate ($f_S$) delayed input sample in each $((\underline{a}-1)N+1)^{th}$ internal filter state, $\underline{a}$ represents all positive integers with $0<\underline{a}\leq M$, and in all other internal filter states the $(k-1)^{th}$ internal output value of the filter to add thereto the multiplied difference inbetween said $k^{th}$ first ringbuffer (7) output sample and said $k^{th}$ second ring buffer (6) output sample calculated by said multiplier (8) to calculate the $k^{th}$ internal output value of the filter.

12. Filter according to anyone of claims 1 to 11, **characterized in that** M equals to one to filter a real input signal (b(1)).

13. Filter according to anyone of claims 1 to 11, **characterized in that** M equals to two to filter a complex IQ-multiplexed input signal (u(1)).

**Patentansprüche**

1. Digitales Filter der Ordnung N

- zum Empfangen eines M-fach gemultiplexten Eingabesignals (b(1); u(1); v(1)) mit einer Abtastrate ($f_C$) und zum Ausgeben eines M-fach gemultiplexten Ausgabesignals (d(1); e(1); y(1)) mit der Abtastrate ($f_S$),
- mit einem modifizierten Filter der Ordnung 1, in welchem N Filterkoeffizienten ($a_n$, $0 \le n \le N-1$) periodisch mit einer Taktfrequenz (fc) geschaltet werden, welche der $M \cdot N$-fachen Abtastrate ($f_S$) entspricht, um das Filter periodisch in $M \cdot N$ interne Filterzustände zu setzen, wobei in jedem dieser Filterzustände ein interner Ausgabewert vor dem Ausgeben eines kompletten Satzes zum M-fach gemultiplexten Ausgabesignal (d(1); e(1); y(1)) berechnet wird,

**gekennzeichnet durch**

- einen ersten Ringpuffer (7) zum Empfangen des Eingabesignals (b(1); u(1); v(1)) mit der Abtastrate ($f_S$) und zum jeweiligen Ausgeben korrespondierender Eingabesätze, welche benötigt werden zum Berechnen der internen Filterzustände, und zwar mit der Taktfrequenz ($f_c$), und
- einen zweiten Ringpuffer (6) zum Empfangen der internen Ausgabewerte der Filter in jedem der internen Filterzustände und zum jeweiligen Ausgeben der korrespondierenden internen Ausgabewerte, welche benötigt werden zum Berechnen des nächsten internen Filterzustands, und zwar mit der Taktfrequenz ($f_c$).

**2.** Filter nach Anspruch 1,
**dadurch gekennzeichnet,**
**dass** jeder interne Ausgabewert a̲N-te einen Satz des Ausgabesignals (d(1); e(1); y(1)) repräsentiert, wobei a̲ eine positive ganze Zahl bezeichnet mit $0 \le a \le M$.

**3.** Filter nach einem der Ansprüche 1 oder 2,
**gekennzeichnet durch**
eine Rückkopplungsschleife (5) zum Empfangen des internen Ausgabewerts des Filters in jedem der internen Filterzustände, zum Verzögern des internen Ausgabewerts um eine Taktzeitspanne ($T_C$) der Taktfrequenz ($f_c$) und zum Ausgeben des internen Ausgabewerts zum Berechnen des nächsten internen Ausgabewerts.

**4.** Filter nach einem der Ansprüche 1 bis 3,
**gekennzeichnet durch**
ein erstes Verzögerungselement (4) zum Halten jedes a̲N-ten internen Ausgabewerts des Filters für eine Zeitspanne oder Periode von N Taktzeitspannen ($T_C$) der Taktfrequenz ($f_c$) und zwar zum Ausgeben des Ausgabesignals (d(1); e(1); y(1)), wobei a̲ eine positive ganze Zahl bezeichnet mit $O \le a \le M$.

**5.** Filter nach einem der Ansprüche 1 bis 4,
**dadurch gekennzeichnet, dass** der erste Ringpuffer (7) aufweist:

- ein drittes Verzögerungselement (7a), welches MN-1 Abtastwerte speichern kann und welches alle Eingabeabtastwerte um MN-1 Abtastperioden ($T_S$) der Abtastrate ($f_S$) verzögert, bevor diese ausgegeben werden,
- einen Eingabeschalter (S0) mit einem ersten festen Anschluss (S00), durch welchen das Eingabesignal (b(1); u(1); v(1)) empfangen wird, einen zweiten festen Anschluss (S01), welcher mit dem Ausgang des dritten Verzögerungselements (7a) verbunden ist, und einen beweglichen Anschluss, welcher mit einem Eingang des dritten Verzögerungselements (7a) und mit einem ersten Ausgang (7c) des ersten Ringpuffers (7) verbunden ist, wobei der bewegliche Anschluss mit dem ersten festen oder fixierten Anschluss (S00) in jedem a̲N-ten internen Filterzustand verbunden ist bzw. mit dem zweiten fixierten oder festen Anschluss (S01) in allen anderen internen Filterzuständen, wobei a̲ alle positiven ganzen Zahlen bezeichnet mit $0 \le a \le M$, und
- einen zweiten Ausgang (7b), welcher mit dem Ausgang des dritten Verzögerungselements (7a) verbunden ist.

**6.** Filter nach Anspruch 5,
**dadurch gekennzeichnet,**

- **dass** der erste Ringpuffer (7) einen dritten Ausgang (7d) aufweist, welcher mit einem Abgriff des dritten Verzögerungselements (7a) verbunden ist, und einen um N-1 Taktperioden ($T_C$) der Taktfrequenz ($f_c$) verzögerten Eingangsabtastwert bereitstellt oder schafft und
- **dass** ein Addierer/Subtrahierer ausgebildet ist, um die vom dritten Ausgang (7d) des ersten Ringpuffers ausgegebenen Werte oder Abtastwerte zu addieren oder zu subtrahieren zu/von jedem a̲N-ten internen Ausgabewert, um einen Tiefpassfilter oder Hochpassfilter zu realisieren, wobei a̲ alle positiven ganzen Zahlen repräsentiert mit $0 \le a \le M$.

7. Filter nach Anspruch 6,
**dadurch gekennzeichnet,**
**dass** das dritte Verzögerungselement (7a) aufweist:

- ein erstes Sub- oder Unterverzögerungselement (7a1), welches (M-1)N Abtastwerte speichern kann und welches Eingabe- oder Eingangsabtastwerte um (M-1)N Taktperioden $(T_C)$ der Taktfrequenz $(f_c)$ vor dem Ausgeben verzögert, wobei sein Eingang mit dem dritten Ausgang (7d) des ersten Ringpuffers (7) verbunden ist und wobei sein Ausgang mit dem zweiten Ausgang (7b) des ersten Ringpuffers (7) verbunden ist, und
- ein zweites Sub- oder Unterverzögerungselement (7a2), welches N-1 Abtastwerte speichern kann und alle Eingangs- oder Eingabeabtastwerte um N-1 Taktperioden $(T_C)$ der Taktfrequenz $(f_c)$ vor ihrer Ausgabe verzögert, wobei sein Eingang mit dem ersten Ausgang (7c) des ersten Ringpuffers (7) verbunden ist und wobei sein Ausgang mit dem dritten Ausgang (7d) des ersten Ringpuffers (7) verbunden ist.

8. Filter nach einem der Ansprüche 1 bis 7,
**dadurch gekennzeichnet,**
**dass** der zweite Ringpuffer (6) aufweist:

- ein viertes Verzögerungselement (6a), welches (M-1)N+1 Abtastwerte speichern kann und welches alle Eingangsabtastwerte oder Eingabeabtastwerte um (M-1)N+1 Taktperioden $(T_C)$ der Taktfrequenz $(f_c)$ vor ihrer Ausgabe verzögert, wobei sein Ausgang mit dem Ausgang (6c) des zweiten Ringpuffers (6) verbunden ist,
- ein fünftes Verzögerungselement (6b), welches N Abtastwerte speichern kann und welches alle Eingangsabtastwerte oder Eingabeabtastwerte um N Taktperioden $(T_C)$ der Taktfrequenz $(f_c)$ vor ihrer Ausgabe verzögert, wobei sein Eingang mit dem Ausgang des vierten Verzögerungselements (6a) verbunden ist, und
- einen Schalter (S2) mit einem ersten festen oder fixierten Anschluss (S20), welcher den internen Ausgabewert empfängt, einen zweiten festen oder fixierten Anschluss (S21), welcher mit dem Ausgang des fünften Verzögerungselements (6b) verbunden ist, und mit einem beweglichen Anschluss, welcher mit dem Eingang des vierten Verzögerungselements (6a) verbunden ist,
- wobei der bewegliche Anschluss mit dem ersten fixierten oder festen Anschluss (S20) in jedem $\underline{a}$N-ten internen Filterzustand und mit dem zweiten fixierten oder festen Anschluss (S21) in allen anderen internen Filterzuständen verbunden ist, wobei $\underline{a}$ alle positiven ganzen Zahlen repräsentiert mit $0<\underline{a}\leq M$.

9. Filter nach einem der Ansprüche 1 bis 4,
**dadurch gekennzeichnet,**
**dass** der erste Ringpuffer (7) aufweist:

- ein drittes Verzögerungselement (7a), welches (M-1)N Abtastwerte speichern kann und welches alle Eingabeabtastwerte oder Eingangsabtastwerte um (M-1)N Taktperioden $(T_C)$ der Taktfrequenz $(f_c)$ vor ihrer Ausgabe verzögert,
- ein sechstes Verzögerungselement (7e), welches N+1 Abtastwerte speichern kann und welches alle Eingangsabtastwerte oder Eingabeabtastwerte um (N+1) Taktperioden $(T_C)$ der Taktfrequenz $(f_c)$ vor ihrer Ausgabe verzögert, wobei sein Eingang mit dem Ausgang des dritten Verzögerungselements (7a) verbunden ist,
- einen Eingabeschalter oder Eingangsschalter (S2), mit einem ersten festen oder fixierten Anschluss (S20), welcher das Eingangssignal oder Eingabesignal (v(1)) empfängt, mit einem zweiten festen oder fixierten Anschluss (S21), welcher mit dem Ausgang des sechsten Verzögerungselements (7e) verbunden ist, und mit einem beweglichen Anschluss, welcher mit dem Eingang des dritten Verzögerungselements (7a) und mit einem ersten Ausgang (11c) des ersten Ringpuffers (11) verbunden ist,
- wobei der bewegliche Anschluss mit dem ersten festen oder fixierten Anschluss (S20) in jedem $((\underline{a}-1)N+1)$-ten internen Filterzustand und mit dem zweiten festen oder fixierten Anschluss (S21) in allen anderen internen Filterzuständen verbunden ist, wobei $\underline{a}$ alle positiven ganzen Zahlen repräsentiert mit $0<\underline{a}\leq M$, und
- einen zweiten Ausgang (11b), welcher mit dem Ausgang des dritten Verzögerungselements (7a) verbunden ist.

10. Filter nach einem der Ansprüche 1 bis 4 oder 9,
**dadurch gekennzeichnet,**
**dass** der zweite Ringpuffer (6) aufweist:

- ein viertes Verzögerungselement (6a), welches MN-2 Abtastwerte speichern kann und welches alle Eingangsabtastwerte um MN-1 Taktperioden $(T_C)$ der Taktfrequenz $(f_c)$ vor ihrer Ausgabe verzögert, wobei sein Ausgang mit dem Ausgang (7b) des zweiten Ringpuffers (7) verbunden ist, und

- einen Schalter (S0) mit einem ersten festen oder fixierten Anschluss (S00), welcher den internen Ausgabewert oder Ausgangswert empfängt, mit einem zweiten festen oder fixierten Anschluss (S01), welcher mit dem Ausgang des vierten Verzögerungselements (6a) verbunden ist, und mit einem beweglichen Anschluss, welcher mit einem Eingang des vierten Verzögerungselements (6a) verbunden ist, wobei der bewegliche Anschluss mit dem ersten festen oder fixierten Anschluss (S00) in jedem $\underline{a}$N-ten internen Filterzustand und mit dem zweiten festen oder fixierten Anschluss (S01) in allen anderen internen Filterzuständen verbunden ist, wobei $\underline{a}$ alle positiven ganzen Zahlen repräsentiert mit O<$\underline{a}$≤M, und
- **dass** der Ausgang (7b) des zweiten Ringpuffers (7) direkt verbunden ist mit einem siebten Verzögerungselement (11), welches einen Abtastwert speichern kann und welches alle Eingangsabtastwerte oder Eingabeabtastwerte um eine Taktperiode ($T_C$) der Taktfrequenz ($f_c$) verzögert.

11. Filter nach einem der Ansprüche 1 bis 10,
    **gekennzeichnet durch**

- einen ersten Addierer (10), welcher einen Ausgangsabtastwert oder Ausgabeabtastwert eines k-ten ersten Ringpuffers (7) mit 0<k≤MN und eines k-ten zweiten Ringpuffers (6) empfängt, um die Differenz zwischen dem Ausgabeabtastwert oder Ausgangsabtastwert des k-ten ersten Ringpuffers (7) und des Ausgabeabtastwerts des k-ten zweiten Ringpuffers (6) auszugeben,
- einen Multiplizierer (8), welcher die Differenz zwischen dem Ausgangsabtastwert oder Ausgabeabtastwert des k-ten ersten Ringpuffers (7) und dem Ausgangsabtastwert oder Ausgabeabtastwert des k-ten zweiten Ringpuffers (6) berechnet, und zwar **durch** den ersten Addierer (10) und **durch** Multiplikation mit einem jeweiligen der N Filterkoeffizienten ($a_n$, 0≤n≤N-1), welcher periodisch mit der Taktfrequenz ($f_c$) geschaltet wird, und
- einen zweiten Addierer (9), welcher die N Abtastwerte der mit der Abtastfrequenz oder Abtastrate ($f_S$) verzögerten Eingangsabtastwerte oder Eingabeabtastwerte in jedem (($\underline{a}$-1)N+1)-ten internen Filterzustand empfängt, wobei $\underline{a}$ alle positiven ganzen Zahlen mit 0<$\underline{a}$≤M bezeichnet, und welcher den [k-1]-ten internen Ausgabewert oder Ausgangswert des Filters in allen anderen internen Filterzuständen empfängt, um dort die multiplizierte Differenz hinzuzuaddieren zwischen dem Ausgangsabtastwert oder Ausgabeabtastwert des k-ten ersten Ringpuffers (7) und dem Ausgangsabtastwerts oder Ausgabeabtastwerts des k-ten zweiten Ringpuffers (6), welcher **durch** den Multiplizierer (8) berechnet wurde, und zwar um den k-ten internen Ausgabewert oder Ausgangswert des Filters zu berechnen.

12. Filter nach einem der Ansprüche 1 bis 11,
    **dadurch gekennzeichnet,**
    **dass** M eins ist, um ein reelles Eingabesignal oder Eingangssignal (b(1)) zu filtern.

13. Filter nach einem der Ansprüche 1 bis 11,
    **dadurch gekennzeichnet,**
    **dass** M zwei ist, um ein komplexes IQ-gemultiplextes Eingabesignal oder Eingangssignal (u(1)) zu filtern.

**Revendications**

1. Filtre numérique d'ordre N recevant un signal d'entrée (b(1) u(1); v(1)) multiplexé M fois et possédant une cadence d'échantillonnage ($f_s$) et délivrant un signal de sortie (d(1); e(1); y(1)) multiplexé M fois et possédant ladite cadence d'échantillonnage ($f_s$), comprenant un filtre d'ordre 1 modifié, dans lequel N coefficients, de filtre ($a_n$, 0≤n≤N-1) sont commutés périodiquement avec une fréquence d'horloge ($f_c$) égale à M.N fois ladite cadence d'échantillonnage ($f_s$) pour régler le filtre périodiquement dans M.N états internes, dans chacun desquels une valeur interne de sortie est calculée avant la délivrance d'un échantillon complet du signal de sortie (d(1); e(1); y(1)) multiplexé M fois, **caractérisé par**

   un premier tampon en anneau (7) recevant le signal d'entrée (b(1); u(1); v(1)) possédant ladite cadence d'échantillonnage ($f_s$) et délivrant respectivement les échantillons de sortie correspondants nécessaires pour calculer un état interne du filtre avec ladite fréquence d'horloge ($f_c$); et
   un second tampon en anneau (6) pour recevoir les valeurs internes de sortie du filtre dans chaque état interne du filtre et délivrant respectivement la valeur interne de sortie correspondante pour le calcul d'un nouvel état interne du filtre avec ladite fréquence d'horloge ($f_c$).

**2.** Filtre selon la revendication 1, **caractérisé en ce que** chaque $\underline{a}$N-ème valeur interne de sortie représente un échantillon du signal de sortie (d(1); e(1); y(1)), a représentant tous les entiers positifs avec 0<$\underline{a}$≤M.

**3.** Filtre selon la revendication 1 ou 2, **caractérisé par** une boucle de réaction (5) recevant la valeur interne de sortie du filtre dans chaque état interne du filtre, retardant cette valeur d'une période d'horloge ($T_C$) correspondant à ladite fréquence d'horloge ($f_c$) et la délivrant pour le calcul de la valeur suivante interne de sortie.

**4.** Filtre selon l'une quelconque des revendications 1 à 3, **caractérisé par** un premier élément de retardement (4) conservant chaque aN-ème valeur interne de sortie, $\underline{a}$ représentant tous les entiers positifs avec 0<$\underline{a}$≤M, du filtre pendant une période correspondant à N périodes d'horloge ($T_C$) de ladite fréquence d'horloge ($f_c$) pour la délivrance du signal de sortie (d(1); e(1); y(1)).

**5.** Filtre selon l'une quelconque des revendications 1 à 4, **caractérisé en ce que** ledit premier tampon en anneau (7) comprend

un troisième élément de retardement (7a), qui peut mémoriser MN-1 valeurs d'échantillonnage et retarde toutes les valeurs d'échantillonnage d'entrée de MN-1 périodes d'échantillonnage ($T_S$) de ladite cadence d'échantillonnage ($f_S$) avant de les délivrer;
un commutateur d'entrée (S0) possédant une première borne fixe (S00) qui reçoit le signal d'entrée (b(1); u (1); v(1)), une seconde borne fixe (S01) qui est connectée à une sortie dudit troisième élément de retardement (7a) et une borne mobile qui est connectée à une entrée dudit troisième élément de retardement (7a) et une première sortie (7c) du premier tampon en anneau (7), ladite borne mobile étant connectée à ladite première borne fixe (S00) dans chaque $\underline{a}$N-ème état interne du filtre, $\underline{a}$ représentant tous les entiers positifs avec 0<$\underline{a}$≤M, et à ladite seconde borne fixe (S01) dans tous les autres états internes du filtre;
une seconde sortie (7b) qui est connectée à la sortie dudit troisième élément de retardement (7a).

**6.** Filtre selon la revendication 5, **caractérisé en ce que**

ledit premier tampon en anneau (7) comprend une troisième sortie (7d) connectée à une prise dudit troisième élément de retardement (7a) fournissant une valeur d'échantillonnage d'entrée retardée de N-1 périodes d'horloge ($T_C$) de ladite fréquence d'horloge ($f_c$), et par
un additionneur/soustracteur prévu pour additionner ou soustraire les échantillons délivrés par ladite troisième sortie (7d) du premier tampon en anneau à/de chaque $\underline{a}$N-ème valeur interne de sortie pour réaliser un filtre passe-bas ou un filtre passe-haut, $\underline{a}$ représentant tous les entiers positifs avec 0<$\underline{a}$≤M.

**7.** Filtre selon la revendication 6, **caractérisé en ce que** ledit troisième élément de retardement (7a) comprend

un premier sous-élément de retardement (7a1) qui peut mémoriser (M-1)N valeurs d'échantillonnage et retarde toutes les valeurs d'échantillonnage d'entrée de (M-1)N périodes d'horloge ($T_C$) de ladite fréquence d'horloge ($f_c$) avant leur délivrance et dont l'entrée est connectée à ladite troisième sortie (7d) dudit premier tampon en anneau (7) et dont la sortie est connectée à ladite seconde sortie (7b) dudit premier tampon en anneau (7), et un second sous-élément de retardement (7a2) qui peut mémoriser N-1 valeurs d'échantillonnage et retarde toutes les valeurs d'échantillonnage d'entrée de N-1 périodes d'horloge ($T_C$) de ladite fréquence d'horloge ($f_c$) avant de les délivrer et dont l'entrée est connectée à ladite première sortie (7c) dudit premier tampon en anneau (7) et dont la sortie est connectée à ladite troisième sortie (7d) dudit premier tampon en anneau (7).

**8.** Filtre selon l'une quelconque des revendications 1 à 7, **caractérisé en ce que** ledit second tampon en anneau (6) comprend

un quatrième élément de retardement (6c) qui peut mémoriser (M-1)N+1 valeurs d'échantillonnage et retarde toutes les valeurs d'échantillonnage d'entrée de (M-1)N+1 périodes d'horloge ($T_C$) de ladite fréquence d'horloge ($f_c$) avant leur délivrance et dont la sortie est connectée à une sortie (6c) dudit second tampon en anneau (6);
un cinquième élément de retardement (6b) qui peut mémoriser N valeurs d'échantillonnage et retarde toutes les valeurs d'échantillonnage d'entrée de N périodes d'horloge ($T_C$) de ladite fréquence d'horloge ($f_c$) avant leur délivrance et dont l'entrée est connectée à la sortie dudit quatrième élément de retardement (6a); et
un commutateur (S2) comportant une première borne fixe (S20) qui reçoit la valeur interne de sortie, une seconde borne fixe (S21) qui est connectée à une sortie dudit cinquième élément de retardement (6b) et une borne mobile qui est connectée à une entrée dudit quatrième élément de retardement (6a), ladite borne mobile étant connectée à ladite première borne fixe (S20) dans chaque $a$N-ème état interne du filtre, $a$ représentant tous les entiers positifs avec 0<$a$≤M, et à ladite seconde borne fixe (S21) dans tous les autres états internes du filtre.

**9.** Filtre selon l'une quelconque des revendications 1 à 4, **caractérisé en ce que** ledit premier tampon en anneau (7) comprend

un troisième élément de retardement (7a) qui peut mémoriser (M-1)N valeurs d'échantillonnage et retarde toutes les valeurs d'échantillonnage d'entrée de (M-1)N périodes d'horloge ($T_C$) de ladite fréquence d'horloge ($f_c$) avant de les délivrer;
un sixième élément de retardement (7e) qui peut mémoriser N+1 valeurs d'échantillonnage et retarde toutes les valeurs d'échantillonnage d'entrée de N+1 périodes d'horloge ($T_C$) de ladite fréquence d'horloge ($f_c$) avant de les délivrer et dont l'entrée est connectée à la sortie dudit troisième élément de retardement (7a);
un commutateur d'entrée (S2) comportant une première borne fixe (S20) qui reçoit le signal de sortie (v(1)), une seconde borne fixe (S21) qui est connectée à une sortie dudit sixième élément de retardement (7e) et une borne mobile qui est connectée à une entrée dudit troisième élément de retardement (7a) et une première sortie (11c) dudit premier tampon en anneau (11), ladite borne mobile étant connectée à ladite première borne fixe (S20) dans chaque ((a-1)N+1)-ème état interne du filtre, $a$ représentant tous les entiers positifs avec 0<$a$≤M, et à ladite seconde borne fixe (S21) dans tous les autres états internes du filtre; et
une seconde sortie (11b) qui est connectée à la sortie dudit troisième élément de retardement (7a).

**10.** Filtre selon l'une quelconque des revendications 1 à 4 ou 9, **caractérisé en ce que** ledit second tampon en anneau (6) comporte

un quatrième élément de retardement (6a) qui peut mémoriser MN-1 valeurs d'échantillonnage et retarde toutes les valeurs d'échantillonnage d'entrée de MN-1 périodes d'horloge ($T_C$) de ladite fréquence d'horloge ($f_c$) avant leur délivrance et dont la sortie est connectée à une sortie (7b) dudit second tampon en anneau (7); et
un commutateur (S0) comportant une première borne fixe (S00) qui reçoit la valeur interne de sortie, une seconde borne fixe (S01) qui est connectée à la sortie dudit quatrième élément de retardement (6a), et une borne mobile qui est connectée à une entrée dudit quatrième élément de retardement (6a), ladite borne mobile étant connectée à ladite première borne fixe (S00) dans chaque $a$N-ème état interne du filtre, $a$ représentant tous les entiers positifs avec 0<$a$≤M, et à ladite seconde borne fixe (S01) dans tous les autres états internes du filtre; et **en ce que**
ladite sortie (7b) dudit second tampon en anneau (7) est connectée directement à un septième élément de retardement (12), qui peut mémoriser une valeur d'échantillonnage et retarde tous les échantillons d'entrée d'une période d'horloge ($T_C$) de ladite fréquence d'horloge ($f_c$) .

**11.** Filtre selon l'une des revendications 1 à 10, **caractérisé par**

un premier additionneur (10) recevant un k-ème échantillon de sortie du premier tampon en anneau (7), 0<k≤MN, et un k-ème échantillon de sortie du second tampon en anneau (6) pour délivrer la différence entre ledit k-ème échantillon de sortie du premier tampon en anneau (7) et ledit k-ème échantillon de sortie du second tampon en anneau (6);
un multiplieur (8) recevant la différence entre ledit k-ème échantillon de sortie du premier tampon en anneau (7) et ledit k-ème échantillon de sortie du second tampon en anneau (6) calculée par ledit premier additionneur (10) et multipliant cette différence par l'un correspondant desdits N coefficients de filtre ($a_n$, 0≤n≤N-1) qui est commuté périodiquement avec ladite fréquence d'horloge ($f_c$); et
un second additionneur (9) recevant les N échantillons de l'échantillon d'entrée possédant la cadence d'échantillonnage ($f_S$), dans chaque ((a-1)N+1)-ème état interne du filtre, $a$ représentant tous les entiers positifs avec 0<$a$≤M, et dans tous les autres états internes du filtre la [k-1]-ème valeur interne de sortie du filtre pour y ajouter la différence multipliée entre ledit k-ème échantillon de sortie du premier tampon en anneau (7) et ledit k-ème échantillon de sortie du second tampon en anneau (6), calculée par ledit multiplieur (8) pour le calcul de la k-ème valeur interne de sortie du filtre.

**12.** Filtre selon l'une quelconque des revendications 1 à 9, **caractérisé en ce que** M est égal à un pour filtrer un signal d'entrée réel (b(1)).

**13.** Filtre selon l'une quelconque des revendications 1 à 11, **caractérisé en ce que** M est égal à deux pour filtrer un signal d'entrée multiplexé selon un multiplexage IQ (u(1)).

Figure 1:

EP 0 977 359 B1

# Figure 2:

EP 0 977 359 B1

EP 0 977 359 B1

# Figure 3:

y(l), M-time multiplexed output signal

v(l), M-time multiplexed input signal

Figure 4:

Figure 5:

EP 0 977 359 B1

**Figure 6:**

Figure 7:

Figure 8: Prior art

Figure 9: Prior art

$63_0$ $63_1$ $63_2$

d(l)

$61_2$ T $62_2$

$a_2$

$64_2$

$65_2$

$61_1$ T $a_1$ T $62_1$

$64_1$

$65_1$

$61_0$ T $a_0$ T $62_0$

$64_0$

b(l)

$65_0$

EP 0 977 359 B1